# EUROPEAN PATENT SPECIFICATION

(11) **EP 2 980 938 B1**
(45) Date of publication and mention of the grant of the patent: **15.01.2020**
(21) Application number: 14179477.6
(22) Date of filing: 01.08.2014
(51) Int. Cl.: H02G 3/08, H05K 5/06

(54) **PROTECTIVE HOUSING FOR A COMPONENT OF A SUBSEA DEVICE**
SCHUTZGEHÄUSE FÜR EINE KOMPONENTE EINER UNTERSEEVORRICHTUNG
BOÎTIER DE PROTECTION D'UN COMPOSANT D'UN DISPOSITIF SOUS-MARIN

(43) Date of publication of application: 03.02.2016
(73) Proprietor: Siemens Aktiengesellschaft, 80333 München (DE)
(72) Inventor: Boe, Ove, 7549 Tanem (NO)

(56) References cited:
- EP-A1- 2 487 327
- EP-A1- 2 571 034
- EP-A1- 2 660 422
- WO-A1-2010/034881
- WO-A2-99/63555
- WO-A2-2012/004608

## Description

### Field of the invention

The invention relates to a subsea device including a subsea enclosure and including an assembly comprising a protective housing of a component of the subsea device and the component, the component being a semiconductor power electronic component.

### Background

Traditionally, oil platforms are used in the offshore oil and gas production. In the operation of offshore oil platforms, it can be necessary to install electrical equipment under water, e. g. for controlling functions of a subsea Christmas tree or a subsea blowout preventer. More recently, processing facilities are being relocated to the ocean floor. Installations on the ocean floor can comprise a range of components, including pumps, compressors and the like which require electric power for operation. Power supply can occur by means of a subsea power grid installed on the ocean floor, which may for example comprise a subsea transformer, a subsea switchgear and subsea variable speed drive for powering the above mentioned subsea loads. It needs to be ensured that the installed equipment operates reliably even under the high pressure that prevails at the rated installation depths which can be 3.000 m or more.

To protect the equipment from the corrosive environment of the surrounding seawater and to deal with the high pressures, pressure compensated enclosures can be used which provide pressure balancing between the ambient seawater pressure and the interior of the enclosure. Such pressure compensated enclosure is generally filled with a dielectric liquid which is essentially incompressible and which further provides heat conduction.

In such configurations, impurities in the dielectric liquid may become a challenge. In particular, particles in the dielectric liquid may follow the fluid stream and may deposit at places with high electric field strength. Such particles may generate an electric breakdown. Furthermore, if there is a fault in an electric or electronic component within the enclosure, the dielectric liquid may become polluted or contaminated, and the pollution may affect other components of the subsea equipment.

The document GB 1 600 095 discloses the use of a housing or casing to encase a semiconductor device and protect the internal circuit elements from contamination. An aperture is formed in the housing and an expansible element having a bellows like structure is mounted to the housing and surrounds the aperture, and defines a sealed variable volume chamber. Although such configuration protects the internal circuit elements from contamination by the environment in which the component is located, it is a relatively complex and difficult to produce structure. Furthermore, a component having such configuration requires a relatively large amount of space. Further, due to its complexity, it is relatively expensive to produce.

Document WO 2012/004608 A2 relates to a cable connection apparatus comprising bulkhead plates with cable glands through which a single cable core is passed.

Document WO 2010/034881 A1 relates to a pressure compensator for a subsea installation which comprises a flow connection to a chamber of the subsea installation.

The document EP 2660422 A1 describes a position monitoring system for subsea bellow compensators. The bellow compensator has an outer end wall and a base at which it is attached to a subsea container in which a variable speed drive is disposed.

### Summary

Accordingly, there is a need for an improved protection of electric or electronic components from contamination in a surrounding medium, and in particular to provide improved means for protecting such component against electric breakdown.

The invention is defined in the independent claim 1. The dependent claims describe embodiments of the invention.

The invention provides a subsea device including an assembly comprising a protective housing of a component of a subsea device. The component is a power electronic component. The component is mounted to a support. The protective housing comprises a cover that is mounted to the support of the component. The cover is formed so as to enclose the component when mounted to the support such that the component is directly located inside a chamber formed by the cover and the support. The cover comprises at least a flexible wall section that is deformable to allow the volume of the chamber to change for providing pressure balancing between a pressure inside the chamber and a pressure outside the chamber. The flexible wall section may thus essentially form a pressure compensator. Additionally or alternatively, the cover comprises a permeable wall section configured to allow a flow of fluid through the permeable wall section. The permeable wall section is further configured to filter a fluid flowing through the permeable wall section.

Since the protective housing allows the component to be directly arranged within the chamber formed by the cover and the support, a compact configuration can be achieved. Furthermore, the configuration is relatively simple, thus allowing a cost-efficient production thereof. The relatively low complexity may further facilitate the assembly of the component, since the cover may be directly mounted to the support. The flexible wall section or the permeable wall section provide pressure compensation, so that the component comprising such protective housing can be employed in a pressure compensated subsea device and can be suitable for use in a water depth of at least 3.000 m. By means of the cover, the electric or electronic component is effectively protected from impurities, particles or pollution which may be present in a medium in which the cover and the protective housing are disposed. This may for example be a dielectric liquid filling a pressure compensated subsea enclosure. By means of the protective housing, such impurities and particles may be kept away from critical areas of the component.

In an embodiment, the cover comprises at least one feed-through for an electrical connection. The feed-through is configured to allow an electrical connection to pass from outside the protective housing into the chamber for electrically contacting the component. By providing the electrical connection through the cover, mounting of the component may be facilitated. Furthermore, the cooling of the component may be improved, as this may allow the support to be implemented in form of a heat sink.

The at least one feed-through may be selective from the group comprising or consisting of: an opening in the cover that is shaped so as to seal against an electric terminal of the component; a bushing provided in the cover; or a conductor molded or cast into the cover. Other possibilities of implementing the feed-through are also conceivable. The conductor which provides the electrical feed-through may thus either be part of the cover, for example by molding the conductor directly into the cover, or may not be part of the cover, such as when simply providing an opening in the cover. A bushing, such as a resin cast bushing, may be directly provided in the cover when manufacturing the cover.

In an embodiment, the cover comprises at least an electric power input feed-through, an electric power output feed-through and a control terminal feed-through. A power electronic component, such as an insulated gate bipolar transistor (IGBT) may thus be employed within the protective housing, and may be contacted with electrical connections through the cover of the protective housing. In particular, all the electrical connections to the electric or electronic component may be provided through the cover of the protective housing, via respective feed-throughs. One or two control terminal feed-throughs may for example be provided for the gate drivers of a power electronic component, such as an IGBT.

In an embodiment, the cover is made of a resilient material. For example, it may be made of a rubber material or of a polymer material. In particular, the flexible wall section may be provided by such resilient material. In some embodiments, the whole cover provides the flexible wall section. In other words, the not only a part of the cover is flexible, but the whole cover may be flexible. In particular, the whole cover can be made said resilient material. In such configuration, the whole cover may deform in order to provide pressure balancing between the pressure inside the chamber and the pressure prevailing in an ambient medium. In particular, the cover may be made of a material that is flexible enough to provide the pressure compensation.

In another embodiment, the cover may be made of a metal. The flexible wall section may be a metal wall of the cover which has a predefined thickness that allows enough deformation for providing said pressure compensation. In another embodiment, the flexible wall section may be a section of resilient material that is provided in the metal cover, it may for example form a wall of the metal cover or may close an opening in the metal cover. Another embodiment, the permeable wall section may be a section of permeable material provided in the metal cover. In such configurations, a relatively stiff cover that provides also mechanical protection may be obtained, while pressure compensation can still be performed, for example due to the thickness of a metal wall section, due to the resilience of a wall section, or due to permeation of the fluid through the wall section.

The permeable wall section may be provided by a fine meshed fabric or by a permeable membrane, which are configured to provide the filtering of fluid. In such configuration, relatively large volume changes of a dielectric liquid filling the chamber may be compensated while no large deformations of a wall portion or of the whole cover are required. Furthermore, by providing said filtering, the electric or electronic component can still be protected efficiently from contamination, impurities or particles in a fluid surrounding the protective housing.

The cover may comprise a filling and/or venting port. By means of such port, the protective housing may be filled fast and efficiently with dielectric liquid, and gases which may be comprised in such liquid or which may form during operation can be released.

The protective housing may comprise bolts or one or more clamps for mounting the cover to the support. As an example, the cover may have a circumferential flange for being mounted to the support, and the flange may be fixed to the support by means of bolts or clamps.

According to the invention, the protective housing comprises the support, and the chamber that is formed by the support and the cover is filled with a dielectric liquid.

In an embodiment, the support may not comprise any feed-throughs. In particular, no electrical connections may be provided through the support. Mounting of the support and cooling of the electric or electronic component may thus be facilitated.

The support may be a heat sink or a printed circuit board. In other configurations, the support may be part of an IGBT module.

The component is a power electronic component, such as an IGBT. In some embodiments, the cover may be configured to cover more than one electric or electronic component. It may for example enclose two, three or more electric or electronic components. In some embodiments, the support may be a circuit board, in particular a printed circuit board (PCB). The cover may be configured to enclose a predetermined number of components on the circuit board, or may even be configured to enclosed all components on the circuit board.

The support may have a flat surface onto which the component is mounted. The cover may also be mounted to the flat surface.

In an embodiment, the cover provides a liquid tight seal to the support. The cover comprises the flexible wall section and is configured to provide together with the support a liquid tight sealing of the chamber. Such configuration may prevent an exchange of liquid between the chamber and the surroundings. Accordingly, the configuration allows the use of different dielectric liquids within the chamber and within for example a subsea device in which the component including the protective housing is disposed. No liquid and thus no pollutions that may be present in the enclosure of the subsea device can enter the chamber.

According to the invention, the subsea device comprises an assembly for subsea use. The assembly comprises a support, a component mounted to the support, wherein the component is a semiconductor power electronic component, and a protective housing that has any of the above described configurations. The cover of the protective housing is mounted to the support to form the chamber, which encloses the component.

The component is a semiconductor component.

The component and the support may for example be part of an IGBT module. The support may for example be a heat sink or a circuit board. The chamber may be filled with dielectric liquid.

In an embodiment, the component comprises an electrical terminal located on the component on the opposite side of the support. The cover comprises a respective feed-through for an electrical connection, the feed through being provided in the cover adjacent to the terminal of the component. In such configuration, the support can be provided in form of a heat sink, and as there might not be any electrical connection on the side of the component with which it is mounted to the support, a relatively large contact area between the component and the support can be achieved. Heat conduction from the component to the support and thus the cooling of the component may be improved. The support may for example be mounted to a wall of a subsea enclosure, so that the heat can be conducted into surrounding seawater, or the support may itself be the wall of a subsea enclosure. In other configurations, the support may be submerged in dielectric liquid filling such subsea enclosure, the dielectric liquid providing heat conduction.

The component may have at least an input terminal and an output terminal, and the cover of the protective housing may comprise an input feed-through and an output feed-through. The assembly may further comprise an electric power input connection provided via the input feed through to the input terminal and an electric power output connection provided via the output feed-through to the output terminal. A stream of electric power may thus be led through the component and may be controlled, for example when the component is implemented as an IGBT, while the component is protected from the ambient medium. By providing the electric connections through the cover, a compact assembly can be achieved, and plural components may be contacted efficiently.

The input feed-through and the output feed-through may each comprise an electric conductor that is hermetically sealed against the cover. An electric connection may thus be provided through the cover while the sealing is maintained.

The assembly may further comprise an input bus bar and an output bus bar. The input bus bar may be connected to the conductor of the input feed through that is connected to the input terminal and the output bus bar may be connected to the conductor of the output feed through that is connected to the output terminal. A compact configuration may thus be obtained in which plural corresponding components can be connected to the input and output bus bars.

The connection is preferably provided by a screw or bolt that reaches through the respective bus bar and the conductor into the respective terminal of the component. Such configuration provides a compact assembly and facilitates the manufacturing thereof. In particular, the electric power input connection and the electric power output connection may be assembled by simply fastening the screw or bolt through the bus bar and the respective conductor into the respective terminal.

In an embodiment, the component further comprises a control terminal, and the cover comprises a control terminal feed through. The assembly may further comprise a control connection provided via the control terminal feed-through to the control terminal of the component. The component may thus be controlled by control signals provided on the control connection through the cover. The control connection may for example provide a connection to the gate drivers of a component in form of an IGBT.

The assembly may comprise plural components, which may be configured similarly. Furthermore, the same cover may comprise further feed-throughs for such further components.

The input bus bar and the output bus bar may connect to plural such components. These may each be provided with an own protective housing including a cover, or may be provided under the same cover of the same protective housing.

According to the invention, the assembly is disposed in a pressure compensated dielectric fluid-filled subsea enclosure. The dielectric fluid in the subsea enclosure may be the same or may be different from the dielectric liquid filling the chamber of the protective housing. Accordingly, incompatible liquids may be used inside the subsea enclosure and inside the chamber.

A further embodiment of the invention provides a subsea variable speed drive including a pressure compensated subsea enclosure and an assembly in any of the above described configurations which is disposed in the pressure compensated subsea enclosure.

It is to be understood that the features mentioned above and those yet to be explained below can be used not only in the respective combinations indicated, but also in other combinations or in isolation, without leaving the scope of the present invention.

### Brief description of the drawings

The foregoing and other features and advantages of the invention will become further apparent from the following detailed description read in conjunction with the accompanying drawings. In the drawings, like reference numerals refer to like elements.
Figure 1 is a schematic drawing showing a protective housing and an assembly according to embodiments of the invention.
Figure 2 is a schematic drawing showing a sectional side view of a protective housing and of an assembly according to embodiments of the invention.

### Detailed description

In the following, embodiments of the invention will be described in detail with reference to the accompanying drawings. It is to be understood that the following description of the embodiments is given only for the purpose of illustration and is not to be taken in a limiting sense.

It should be noted that the drawings are to be regarded as being schematic representations only, and elements in the drawings are not necessarily to scale with each other. Rather, the representation of the various elements is chosen such that their function and general purpose become apparent to a person skilled in the art.

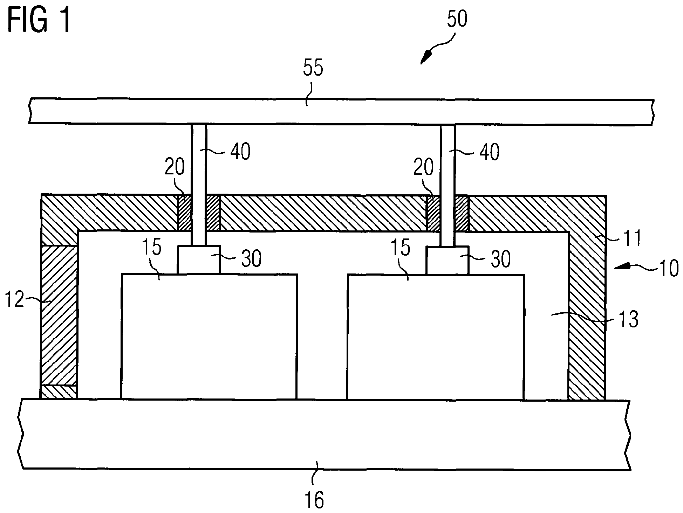

Figure 1 is a schematic diagram showing a protective housing 10 and an assembly 50 according to an embodiment of the invention. The protective housing 10 comprises the cover 11 which is mounted to the support 16. On the support 16, two electronic components 15 are mounted. Cover.11 and support 16 form a chamber 13. In operation, chamber 13 is filled with dielectric liquid.

Cover 11 comprises feed-throughs 20 through which an electrical connection is provided towards the respective component 15. Component 15 has for example an electric terminal 30, and an electric connection 40 passes through the feed through 20 into the chamber 13 and is connected to the terminal 30. Accordingly, in the configuration of figure 1, the component 15 can be contacted electrically through the cover 11. Depending on the type of component 15 and the number of electric terminals component 15 has, a corresponding number of feed-throughs 20 may be provided in the cover 11 (per component 15 disposed in chamber 13). The support 16 may not comprise any electrical through-connections. This has the advantage that a relatively large contact area is obtained between component 15 and support 16, thereby improving the heat transfer. Furthermore, support 16 may be mounted directly to a wall of a subsea enclosure (or with an intervening heat transfer element), so that heat transfer into the surrounding seawater can be improved. In other embodiments, the support 16 may be the wall of a subsea enclosure.

Cover 11 comprises at least one wall section 12 which can be implemented as a flexible wall section that is deformable to allow the volume of the chamber 13 to change for providing pressure compensation. For example if the dielectric liquid filling chamber 13 expands due to a change in temperature, the wall section 12 may be deformed accordingly so as to accommodate for the change in volume. The wall section 12 is deformed by the pressure difference between the inside of chamber 13 and the pressure in the medium surrounding the cover 11, and by the deformation, the pressure inside chamber 13 is balanced to the pressure prevailing in the ambient medium. Wall section 12 thus provides pressure compensation.

In some embodiments, the cover 11 may have one or more predetermined wall sections that are made of a flexible material, in particular a resilient material which is capable of providing the required deformation for pressure compensation. As an example, cover 11 may be made of a metal, and openings in the cover may be closed by a deformable membrane which constitutes the flexible wall section. In other embodiments, the whole cover may be flexible. In particular, the whole cover may be made of a resilient material, such as a polymer material, rubber or the like. Since in such configuration, any part of the cover 11 might be deformable, the capacity for pressure compensation and thus to accommodate volume changes of the liquid filling chamber 13 is increased.

In other embodiments, the wall section 12 may be a permeable wall section that is configured to allow a flow of fluid through the wall section 12. As an example, the wall section 12 may in such embodiment be made of a fine meshed fabric or a permeable membrane or the like, which may close an opening in the cover 11. Cover 11 may for example be made of a plastic, rubber, polymer or metal material and have one or more openings, which are closed by such permeable material. Accordingly, if the volume of the liquid filling chamber 13 expands or contracts, for example due to temperature changes, the liquid can flow out of or into chamber 13 through the wall section 12, so that the build-up of a pressure difference across cover 11 is avoided. Again, the wall section 12 thus provides pressure balancing.

In an embodiment in which the wall portion 12 is a flexible wall portion, the cover 11 can be sealed in a fluid tight manner. Accordingly, different dielectric liquid may be used within the chamber 13 and outside of the chamber 13, since an exchange of the liquids can be prevented. Pollution, contamination, impurities and particles which may be present in the liquid surrounding the cover 11 can thus be prevented from entering the chamber 13, thereby protecting the component 15 from such pollution and eventually from electrical breakdown. When wall section 12 is implemented as a permeable wall section, the permeable wall section is formed so that the liquid flowing through wall section 12 is filtered in order to prevent any of such impurities or particles from entering the chamber 13. A similar protection of the component 15 may thus be achieved.

In other embodiments, the support 16 may be a printed circuit board, or it may be part of a module carrying the component 15.

The feed-through 20 may be provided in form of a conductor that is molded or cast directly into the cover 11 when manufacturing the cover 11. In the embodiment illustrated in figure 1, the feed-through 20 is provided by a bushing which comprises an internal conductor and an outer insulating material surrounding the conductor. The bushing can be directly embedded into the enclosure 11 when manufacturing the enclosure 11, or the bushings may be mounted into holes provided in enclosure 11, for example by means of an interference fit or press-fit, by some adhesive, by soldering or welding or the like, depending on the configuration of cover 11.

In even further embodiments, the feed-through 20 may simply be provided by a respective hole in cover 11. The cover 11 may then be placed over the component 15 in such way that the terminal 30 of component 15 penetrates the feed-through 20 and that a sealing is established between the feed-through 20 and the terminal 30. Similarly, this may be achieved by means of an interference fit, by some sealing component, seal, adhesive or some method such as soldering or welding or the like.

The assembly 50 illustrated in figure 1 comprises the protective housing 10 including the cover 11, it further comprises the support 16, the component 15, and the electric connection 40. Furthermore, it may comprise a bus bar 55 for electrically contacting the electric component 15 via the electric connection 40. As can be seen, such configuration can provide a compact assembly 50 in which one or plural components 15 can be contacted electrically, while the components 15 are at the same time cooled efficiently and protected against particles or pollution present in an ambient medium.

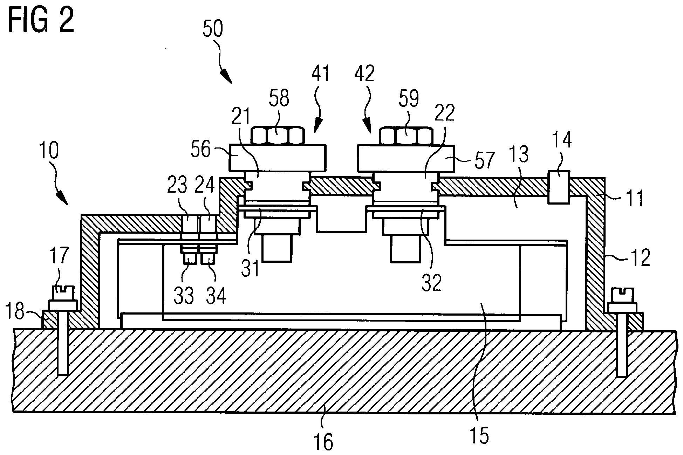

Figure 2 is a schematic drawing showing a sectional side view of a particular implementation of the protective housing 10 and the assembly 50 of figure 1. Accordingly, the explanations given above with respect to figure 1 are equally applicable to the embodiment of figure 2.

In figure 2, the cover 11 further has a fluid filling and venting port 14. The port 14 allows a complete filling of the chamber 13 with dielectric liquid. Furthermore, it allows gases to be vented from chamber 13, for example when filling chamber 13 with liquid, or for venting gases that may have formed during operation.

Cover 11 further comprises a flange 18. Cover 11 may for example have a rectangular shape with a rectangular opening, around which the flange 18 is provided. By means of bolts or screws 17, the flange 18 may be affixed to the support 16. Furthermore, a sealing element such as an O-ring seal or the like may be provided between the cover 11 and the support 16 in order to provide a fluid tight sealing. Such O-ring seal may sit on the flange 18. Other fastening elements for mounting the cover 11 to the support 16 are also conceivable, such as clamps or the like.

In the embodiment of figure 2, the whole cover 11 is made of a resilient material and thus capable of deforming in order to provide pressure compensation. Furthermore, it provides a fluid tight seal for chamber 13 in order to prevent the exchange of liquids. It should be clear that in other embodiments, only a wall section of cover 11 may be flexible, or a permeable wall section may be provided, as described above.

In the embodiment of figure 2, the component 15 which can be implemented as a semiconductor component, in particular a power electronic component, has an input terminal 31 and an output terminal 32 for receiving electric power and for giving out electric power. Terminals 31 and 32 are provided on a side of component 15 that is opposite of the support 16. The cover 11 comprises a respective input feed-through 21 and a respective output feed-through 22. In the example of figure 2, input and output feed-throughs 21, 22 are provided by an electric conductor which is directly cast or molded into the cover 11. The conductors of feed-throughs 21, 22 are located directly adjacent to the respective terminals 31, 32. Accordingly, a very compact configuration of the assembly 50 can be obtained. Furthermore, assembly 50 comprises an input bus bar 56 and an output bus bar 57. These are shown in cross section in the drawing of figure 2, i.e. the bus bars 56, 57 run perpendicular to the drawing plane. Bus bars 56 and 57 are located directly adjacent to the conductors of the respective feed-throughs 21, 22.

In the embodiment of figure 2, the bus bars 56, 57, the conductors of feed-throughs 21, 22 and the terminals 31, 32 are provided with through-holes. Bolts or screws 58, 59 are screwed through the respective bus bar 56, 57 and the conductor of the respective feed-through 21, 22 into the respective terminal 31, 32. This way, an electric power input connection 41 and an electric power output connection 42 can be provided that are relatively compact and that have a relatively low resistance. A very efficient and compact contacting of the terminals 31, 32 of the component 50 is thus achieved.

Furthermore, the component 15 has control terminals 33, 34. The cover 11 comprises respective control terminal feed-throughs 23 and 24. Again, they are provided directly adjacent to the respective control terminals 33, 34. The feed-throughs 23, 24 in cover 11 can be configured as described above with respect to any of the feed-throughs 20, 21 or 22. By means of the feed-throughs 23, 24 and terminals 33, 34 a control connection to the component 15 can be provided. If the component 15 is implemented as an IGBT, the control connection may for example be used to provide control signals to the gate of the IGBT.

It should be clear that components other than an IGBT may be used with the protective housing 10 and the assembly 50. Further, although in the above description, electrical connections to the component 15 are preferably provided through cover 11, they may in other embodiments also be provided through the support 16.

Assembly 50 may for example be an IGBT module, with support 16 being a heat sink of such module. The assembly 50 may for example be mounted in a subsea variable speed drive, in particular within a pressure compensated subsea enclosure thereof.

While specific embodiments are disclosed herein, various changes and modifications can be made without departing from the scope of the invention. The present embodiments are to be considered in all respects as illustrative and non-restrictive, and all changes coming within the meaning and equivalency range of the appended claims are intended to be embraced therein.

## Claims

1. A subsea device, comprising
- a subsea enclosure, wherein the subsea enclosure is pressure compensated and dielectric fluid-filled, and
- an assembly for subsea use, wherein the assembly is disposed in the dielectric fluid-filled subsea enclosure, the assembly comprising:
- a support (16),
- a component (15) mounted to the support (16), the component being a semiconductor power electronic component,
- a protective housing (10) comprising:
o a cover (11) that is mounted to the support (16) of the component (15), the cover (11) being formed so as to enclose the electronic component (15) such that the electronic component (15) is directly located inside a chamber (13) formed by the cover (11) and the support (16),
wherein the chamber (13) formed by the support (16) and the cover (11) is filled with a dielectric liquid,
wherein the cover (11) comprises at least
o a flexible wall section that is deformable to allow the volume of the chamber (13) to change for providing pressure balancing between a pressure inside the chamber (13) and a pressure outside the chamber (13), or
o a permeable wall section configured to allow a flow of fluid through the permeable wall section, the permeable wall section being further configured to filter fluid flowing through the permeable wall section.

2. The subsea device according to claim 1, wherein the cover (11) comprises at least one feed-through (20) for an electrical connection (40), the feed-through (20) being configured to allow the electrical connection (40) to pass from outside the protective housing (10) into the chamber (13) for electrically contacting the component (15).

3. The subsea device according to claim 2, wherein the at least one feed-through (20) is selected from the group comprising
- an opening in the cover (11) that is shaped so as to seal against an electric terminal (30) of the component (15),
- a bushing provided in the cover (11), or
- a conductor molded or cast into the cover (11).

4. The subsea device according to claim 2 or 3, wherein the cover (11) comprises at least an input feed-through (21), an output feed-through (22) and a control terminal feed-through (23, 24).

5. The subsea device according to any of the preceding claims, wherein the cover (11) is made of a resilient material, in particular a rubber or polymer material.

6. The subsea device according to any of claims 1-4, wherein the cover (11) is made of metal, wherein said flexible wall section is a metal wall of the cover (11) having a predefined thickness or is a section of resilient material provided in the metal cover, or wherein the permeable wall section is a section of permeable material provided in the metal cover, respectively.

7. The subsea device according to any of the preceding claims, wherein the permeable wall section is provided by a meshed fabric or by a permeable membrane configured to provide said filtering of fluid.

8. The subsea device according to any of the preceding claims, wherein the cover (11) provides a liquid tight seal to the support (16); the cover comprising said flexible wall section, the cover (11) and the support (16) being configured to provide a liquid tight sealing of the chamber.

9. The subsea device according to any of the preceding claims, wherein the component (15) comprises an electrical terminal (30) located on the component (15) on an opposite side of the support (16), wherein the cover (11) comprises a respective feed-through (20) for an electrical connection (40), the feed-through (20) being provided in the cover (11) adjacent to the terminal (30) of the component (15).

10. The subsea device according to any of the preceding claims, wherein the component (15) has at least an input terminal (31) and an output terminal (32), the cover comprising an input feed-through (21) and an output feed-through (22), the assembly (50) further comprising an electric power input connection (41) provided via the input feed-through (21) to the input terminal (31) and an electric power output connection (42) provided via the output feed-through (22) to the output terminal (32).

11. The subsea device according to claim 10, wherein the input feed-through (21) and the output feed-through (22) each comprise an electric conductor that is hermetically sealed against the cover (11).

12. The subsea device according to claim 11, wherein the assembly further comprises an input busbar (56) and an output busbar (57), wherein the input busbar (56) is connected to the conductor of the input feed-through (21) that is connected to the input terminal (31), and wherein the output busbar (57) is connected to the conductor of the output feed-through (22) that is connected to the output terminal (32), wherein the connection is preferably provided by a screw or bolt (58, 59) that reaches through the respective busbar (56, 57) and conductor into the respective terminal (31, 32).

13. The subsea device according to any of the preceding claims, wherein the component (15) further comprises a control terminal (33, 34), the cover (11) comprising a control terminal feed-through (23, 24), wherein the assembly (50) further comprises a control connection provided via the control terminal feed-through (23, 24) to the control terminal (33, 34) of the component.

## Patentansprüche

1. Unterseevorrichtung, die Folgendes umfasst:
- ein Unterseegehäuse, wobei das Unterseegehäuse druckkompensiert und mit einem dielektrischen Fluid gefüllt ist, und
- eine Anordnung für den Unterseeeinsatz, wobei sich die Anordnung in dem mit einem dielektrischen Fluid gefüllten Unterseegehäuse befindet und Folgendes umfasst:
- einen Träger (16),
- ein an dem Träger (16) befestigtes Bauelement (15), wobei das Bauelement ein elektronisches Leistungshalbleiterbauelement ist,
- ein Schutzgehäuse (10), das Folgendes umfasst:
o eine Abdeckung (11), die an dem Träger (16) des Bauelements (15) befestigt ist, wobei die Abdeckung (11) so gebildet ist, dass sie das elektronische Bauelement (15) derart einschließt, dass sich das elektronische Bauelement (15) direkt innerhalb einer von der Abdeckung (11) und dem Träger (16) gebildeten Kammer (13) befindet,
wobei die von dem Träger (16) und der Abdeckung (11) gebildete Kammer (13) mit einem dielektrischen Fluid gefüllt ist,
wobei die Kammer (11) wenigstens Folgendes umfasst:
o einen flexiblen Wandabschnitt, der verformbar ist, damit sich das Volumen der Kammer (13) ändern kann, um einen Druckausgleich zwischen einem Druck innerhalb der Kammer (13) und einem Druck außerhalb der Kammer (13) herbeizuführen, oder
o einen durchlässigen Wandabschnitt, der dazu konfiguriert ist, einen Fluidstrom durch den durchlässigen Wandabschnitt zu ermöglichen, wobei der durchlässige Wandabschnitt ferner dafür konfiguriert ist, durch den durchlässigen Wandabschnitt strömendes Fluid zu filtern.

2. Unterseevorrichtung nach Anspruch 1, wobei die Abdeckung (11) wenigstens eine Durchführung (20) für eine elektrische Verbindung (40) umfasst, wobei die Durchführung (20) dafür konfiguriert ist, die elektrische Verbindung (40) von außerhalb des Schutzgehäuses (10) in die Kammer (13) zur elektrischen Kontaktierung des Bauelements (15) zu ermöglichen.

3. Unterseevorrichtung nach Anspruch 2, wobei die wenigstens eine Durchführung (20) ausgewählt ist aus der Gruppe bestehend aus:
- einer Öffnung in der Abdeckung (11), die so geformt ist, dass sie gegen einen elektrischen Anschluss (30) des Bauelements (15) abdichtet,
- einer in der Abdeckung (11) vorgesehenen Durchführung oder
- einem in die Abdeckung (11) eingeformten oder eingegossenen Leiter.

4. Unterseevorrichtung nach Anspruch 2 oder 3, wobei die Abdeckung (11) wenigstens eine Eingangsdurchführung (21), eine Ausgangsdurchführung (22) und eine Steueranschlussdurchführung (23, 24) umfasst.

5. Unterseevorrichtung nach einem der vorhergehenden Ansprüche, wobei die Abdeckung (11) aus einem elastischen Material, insbesondere einem Gummi oder Polymermaterial hergestellt ist.

6. Unterseevorrichtung nach einem der Ansprüche 1 bis 4, wobei die Abdeckung (11) aus Metall hergestellt ist, wobei der flexible Wandabschnitt eine Metallwand der Abdeckung (11) mit einer vordefinierten Stärke ist oder ein Abschnitt aus in der Metallabdeckung angebrachtem elastischem Material ist bzw. wobei der durchlässige Wandabschnitt ein Abschnitt aus in der Metallabdeckung angebrachtem durchlässigem Material ist.

7. Unterseevorrichtung nach einem der vorhergehenden Ansprüche, wobei der durchlässige Wandabschnitt gebildet ist von einem Gittergewebe oder von einer durchlässigen Membran, die dazu ausgebildet ist, die Filterung des Fluids zu ermöglichen.

8. Unterseevorrichtung nach einem der vorhergehenden Ansprüche, wobei die Abdeckung (11) eine flüssigkeitsdichte Abdichtung zu dem Träger (16) bereitstellt, wobei die Abdeckung den flexiblen Wandabschnitt umfasst, wobei die Abdeckung (11) und der Träger (16) dazu ausgebildet sind, eine flüssigkeitsdichte Abdichtung der Kammer bereitzustellen.

9. Unterseevorrichtung nach einem der vorhergehenden Ansprüche, wobei das Bauelement (15) einen elektrischen Anschluss (30) umfasst, der sich auf dem Bauteil (15) auf einer gegenüberliegenden Seite des Trägers (16) befindet, wobei die Abdeckung (11) eine jeweilige Durchführung für einen elektrische Verbindung (40) umfasst, wobei die Durchführung (20) in der Abdeckung (11) benachbart dem Anschluss (30) des Bauelements (15) bereitgestellt ist.

10. Unterseevorrichtung nach einem der vorhergehenden Ansprüche, wobei das Bauelement (15) wenigstens einen Eingangsanschluss (31) und einen Ausgangsanschluss (32) aufweist, wobei die Abdeckung (11) eine Eingangsdurchführung (21) und eine Ausgangsdurchführung (22) umfasst, wobei die Anordnung (50) ferner eine über die Eingangsdurchführung (21) zu dem Eingangsanschluss (31) bereitgestellte elektrische Leistungseingangsverbindung (41) und eine über die Ausgangsdurchführung (22) zu dem Ausgangsanschluss (32) bereitgestellte elektrische Leistungsausgangsverbindung (42) umfasst.

11. Unterseevorrichtung nach Anspruch 10, wobei die Eingangsdurchführung (21) und die Ausgangsdurchführung (22) jeweils einen elektrischen Leiter umfassen, der hermetisch gegen die Abdeckung (11) abgedichtet ist.

12. Unterseevorrichtung nach Anspruch 11, wobei die Anordnung ferner eine Eingangssammelschiene (56) und eine Ausgangssammelschiene (57) umfasst, wobei die Eingangssammelschiene (56) mit dem Leiter der Eingangsdurchführung (21) verbunden ist, die mit dem Eingangsanschluss (31) verbunden ist, und wobei die Ausgangssammelschiene (57) mit dem Leiter der Ausgangsdurchführung (22) verbunden ist, die mit dem Ausgangsanschluss (32) verbunden ist, wobei die Verbindung vorzugsweise durch eine Schraube oder einen Bolzen (58, 59) gebildet ist, die bzw. der durch die jeweilige Sammelschiene (56, 57) und den Leiter in den jeweiligen Anschluss (31, 32) reicht.

13. Unterseevorrichtung nach einem der vorhergehenden Ansprüche, wobei das Bauelement (15) ferner einen Steueranschluss (33, 34) umfasst, wobei die Abdeckung (11) eine Steueranschlussdurchführung (23, 24) umfasst, wobei die Anordnung (50) ferner eine über die Steueranschlussdurchführung (23, 24) zu dem Steueranschluss (33, 34) des Bauelements bereitgestellte Steuerverbindung umfasst.

## Revendications

1. Dispositif sous-marin, comprenant
- un caisson sous-marin dans lequel le caisson sous-marin est à pression compensée et rempli de liquide diélectrique, et
- un assemblage pour un usage sous-marin, dans lequel l'assemblage est disposé dans le caisson sous-marin rempli de fluide diélectrique, l'assemblage comprenant :
- un support (16),
- un composant (15) monté sur le support (16), le composant étant un composant électronique semi-conducteur de puissance,
- un boîtier protecteur (10) comprenant :
o un couvercle (11) qui est monté sur le support (16) du composant (15), le couvercle (11) étant formé de sorte à entourer le composant électronique (15) afin que le composant électronique (15) soit directement situé à l'intérieur d'une chambre (13) formée par le couvercle (11) et le support (16),
dans lequel la chambre (13) formée par le support (16) et le couvercle (11) est remplie d'un fluide diélectrique,
dans lequel le couvercle (11) comprend au moins
o une section de paroi flexible qui est déformable pour permettre au volume de la chambre (13) de changer afin de fournir une pression s'équilibrant entre une pression à l'intérieur de la chambre (13) et une pression à l'extérieur de la chambre (13), ou
o une section de paroi perméable configurée pour permettre un écoulement de fluide à l'intérieur de la section de paroi perméable, la section de paroi perméable étant en outre configurée pour filtrer le fluide s'écoulant à travers la section de paroi perméable.

2. Dispositif sous-marin selon la revendication 1 dans lequel le couvercle (11) comprend au moins une traversée (20) pour une connexion électrique (40), la traversée (20) étant configurée pour permettre à la connexion électrique (40) de passer depuis l'extérieur du boîtier protecteur (10) dans la chambre (13) afin de contacter électriquement le composant (15) .

3. Dispositif sous-marin selon la revendication 2 dans lequel l'au moins une traversée (20) est sélectionnée à partir d'un groupe comprenant
- une ouverture dans le couvercle (11) qui est formée de sorte à isoler du terminal électrique (30) du composant (15),
- une douille fournie dans le couvercle (11), ou
- un conducteur moulé ou coulé dans le couvercle (11).

4. Dispositif sous-marin selon la revendication 2 ou 3 dans lequel le couvercle (11) comprend au moins une traversée d'entrée (21), une traversée de sortie (22) et une traversée du terminal de contrôle (23, 24).

5. Dispositif sous-marin selon l'une quelconque des revendications précédentes dans lequel le couvercle (11) est constitué d'un matériau élastique, en particulier un matériau caoutchouc ou polymère.

6. Dispositif sous-marin selon l'une des revendications 1-4 dans lequel le couvercle (11) est constitué de métal, dans lequel ladite section de paroi flexible est une paroi métallique du couvercle (11) ayant une épaisseur prédéfinie ou est une section de matériau élastique fournie dans le couvercle en métal, ou dans lequel la section de paroi perméable est une section de matériau perméable fournie dans le couvercle en métal, respectivement.

7. Dispositif sous-marin selon l'une quelconque des revendications précédentes dans lequel la section de paroi perméable est fournie par un tissu maillé ou par une membrane perméable configurée pour fournir ledit filtrage du fluide.

8. Dispositif sous-marin selon l'une quelconque des revendications précédentes dans lequel le couvercle (11) fournit un joint étanche avec le support (16) ; le couvercle comprenant ladite section de paroi flexible, le couvercle (11) et le support (16) étant configurés pour fournir un joint liquide étanche avec la chambre.

9. Dispositif sous-marin selon l'une quelconque des revendications précédentes dans lequel le composant (15) comprend un terminal électrique (30) situé sur le composant (15) sur une face opposée du support (16), dans lequel le couvercle (11) comprend une traversée (20) respective pour une connexion électrique (40), la traversée (20) étant fournie dans le couvercle (11) adjacent au terminal (30) du composant (15) .

10. Dispositif sous-marin selon l'une quelconque des revendications précédentes dans lequel le composant (15) possède au moins un terminal d'entrée (31) et un terminal de sortie (32), le couvercle comprenant une traversée d'entrée (21) et une traversée de sortie (22), l'assemblage (50) comprenant en outre une connexion d'entrée de puissance électrique (41) fournie via la traversée d'entrée (21) vers le terminal d'entrée (31) et une connexion de sortie de puissance électrique (42) fournie via la traversée de sortie (22) vers le terminal de sortie (32).

11. Dispositif sous-marin selon la revendication 10 dans lequel la traversée d'entrée (21) et la traversée de sortie (22) comprennent chacune un conducteur électrique qui est scellé hermétiquement contre le couvercle (11).

12. Dispositif sous-marin selon la revendication 11 dans lequel l'assemblage comprend en outre une barre-bus d'entrée (56) et une barre-bus de sortie (57), dans lequel la barre-bus d'entrée (56) est connectée au conducteur de la traversée d'entrée (21) qui est connecté au terminal d'entrée (31) et dans lequel la barre-bus de sortie (57) est connectée au conducteur de la traversée de sortie (22) qui est connectée au terminal de sortie (32), dans lequel la connexion est de préférence fournie par une vis ou un boulon (58, 59) qui passe à travers la barre-bus (56, 57) respective et le conducteur dans le terminal respectif (31, 32).

13. Dispositif sous-marin selon l'une quelconque des revendications précédentes dans lequel le composant (15) comprend en outre un terminal de contrôle (33, 34), le couvercle (11) comprenant une entrée du terminal de contrôle (23, 24), dans lequel l'assemblage (50) comprend en outre une connexion de contrôle fournie via l'entrée du terminal de contrôle (23, 24) au terminal de contrôle (33, 34) du composant.
